# EUROPÄISCHE PATENTSCHRIFT

(11) **EP 0 625 795 B1**
(45) Veröffentlichungstag und Bekanntmachung des Hinweises auf die Patenterteilung: **18.09.1996**
(21) Anmeldenummer: 94107351.2
(22) Anmeldetag: 11.05.1994
(51) Int. Cl.: H01L 21/311, C23F 1/08, H01L 21/00

(54) **Verfahren zur nasschemischen Behandlung von Werkstücken**
Process for the wet chemical processing of objects
Procédé pour le traitement chimique en phase liquide de pièces

(30) Priorität: 13.05.1993 DE 4316096
(43) Veröffentlichungstag der Anmeldung: 23.11.1994
(73) Patentinhaber: Wacker Siltronic Gesellschaft für Halbleitermaterialien Aktiengesellschaft, 84489 Burghausen (DE)
(72) Erfinder: Stadler, Max, Dr., D-84533 Haiming (DE); Schwab, Günter, D-84547 Emmerting (DE); Romeder, Peter, D-84489 Burghausen (DE)
(74) Vertreter: Rimböck, Karl-Heinz, Dr.

(56) Entgegenhaltungen:
- DE-A- 417 507
- DE-A- 3 805 076
- GB-A- 2 228 424
- PATENT ABSTRACTS OF JAPAN vol. 6, no. 143 (C-117) 3. August 1982 & JP-A-57 065 325 (SUZUKI TAKASHI) 20. April 1992

## Beschreibung

Die Erfindung betrifft ein Verfahren zur naßchemischen Behandlung von Werkstücken aus Halbleitermaterial durch Anströmen der Werkstücke mit einem begasten Behandlungsmedium.

Aus der Patentschrift US-5,014,727 oder aus der Patentanmeldung mit der Veröffentlichungsnummer GB-2 228 424 A ist eine Vorrichtung bekannt, mit der Halbleiterscheiben gewaschen werden können. Die Halbleiterscheiben sind, ohne sich gegenseitig zu berühren, in einem Tragegestell gestapelt. Das Tragegestell ist in eine Wanne mit Waschflüssigkeit getaucht. Eine Pumpe fördert aus der Wanne überlaufende Flüssigkeit über einen Filter durch den Warnenboden zurück in die Wanne, so daß die Halbleiterscheiben von der Flüssigkeit angeströmt werden. Unterhalb des Tragegestells befindet sich auf dem Wannenboden ein Blasenerzeuger, mit dem Gasbläschen zur Durchmischung in die Flüssigkeit geblasen werden.

Nachteilig an dieser Vorrichtung und dem damit durchführbaren Verfahren ist, daß die Verteilung der Gasbläschen in der Flüssigkeit nicht homogen ist und deshalb zu lokal unterschiedlichen Strömungsverhältnissen führt. Die Halbleiterscheiben werden infolgedessen nicht gleichmäßig, sondern mit unterschiedlicher Intensität von der Waschflüssigkeit umspült. Dies führt insbesondere dann, wenn neben einer reinigenden Wirkung der Behandlung auch eine materialabtragende Ätzbehandlung durch die Flüssigkeit und/oder das Gas vorgesehen ist, zu einer ungleichmäßigen Behandlung der Werkstückoberflächen und einem unerwünschten, ortsabhängigen Behandlungserfolg.

In den Patent Abstracts of Japan, Band 3, Nr. 143 (C-117), die sich auf die japanische Patentanmeldung JP-A-57 065 325 beziehen, ist eine Vorrichtung und ein Verfahren zum Auslaugen und Oxidieren von Rohmetall offenbart. Als Oxidationsmittel wird Luft eingesetzt, die auf hydrodynamischem Weg in Form von Luftblasen in eine Flüssigkeit gemischt und mit dem Rohmetall in Kontakt gebracht wird. Das Gemisch wird zuvor gegen eine Prallplatte geführt, um die Luftblasen gleichmäßig zu verteilen und so eine effektive Oxidation des Rohmetalls zu gewährleisten.

In der Patentschrift DE-417 507 ist ein Verfahren zur Behandlung von Flüssigkeiten mit Gasen beansprucht, bei dem Gase der Flüssigkeit in einer rotierenden Pumpe zugesetzt werden und das dabei entstehende, innige Gemisch von Gas und Flüssigkeit gezwungen wird, auf einem beliebig langen Weg gemeinsam zu strömen, wobei die Strömungsgeschwindigkeit von Gas und Flüssigkeit verschieden groß ist.

Die Aufgabe der Erfindung bestand darin, ein Verfahren zu entwickeln, das eine gleichmäßige naßchemische Behandlung an jedem Ort der Oberfläche von Werkstücken aus Halbleitermaterial sicherstellt.

Gelöst wird die Aufgabe durch ein Verfahren zur naßchemischen Behandlung von Werkstücken aus Halbleitermaterial durch Anströmen der Werkstücke mit einem begasten Behandlungsmedium, das dadurch gekennzeichnet ist, daß ein Gas und eine Flüssigkeit in einer Förderpumpe intensiv vermischt werden und die Förderpumpe eine homogene Dispersion feinster Gasbläschen in der Flüssigkeit abgibt, mit der die Werkstücke behandelt werden.

Homogen dispergiert im Sinne der Erfindung bedeutet, daß die Konzentration an Gasbläschen in der Flüssigkeit in jedem stichprobenartig ausgewählten Probevolumen des Behandlungsmediums praktisch gleich ist. Ferner hat es sich als besonders vorteilhaft herausgestellt, Vorsorge zu treffen, daß die in der Flüssigkeit dispergierten Gasbläßchen möglichst klein sind, so daß sie nur einer sehr geringen Auftriebskraft unterliegen und deshalb ihre Relativgeschwindigkeit zur Flüssigkeit bezüglich der Geschwindigkeitskomponente in Richtung auf das Werkstück null oder nahezu null ist.

Sehr wirksame Vorrichtungen zur Erzeugung geeigneter Behandlungsmedien im Sinne der Erfindung sind Förderpumpen, die Gase und Flüssigkeiten bewegen können. Wird einer solchen Pumpe ansaugseitig sowohl ein Gas als auch eine Flüssigkeit angeboten, so erfolgt in der Pumpe eine intensive Vermischung des Gases und der Flüssigkeit. Die Pumpe gibt dann druckseitig eine homogene Dispersion feinster Gasbläschen in der Flüssigkeit ab. Dieses Behandlungsmedium zeigt gegenüber einer Flüssigkeit, in die ein Blasenerzeuger ("bubbler") Gasbläschen preßt, veränderte Eigenschaften. Während im letztgenannten Fall die Gasbläschen durch die Flüssigkeit wirbeln und diese dabei vermischen, treten bei den homogen dispergierten Gasbläschen keine, dies bewirkenden, lokalen Strömungsunterschiede mehr auf. Eine zusätzliche Durchmischung der Flüssigkeit ist in diesem Fall auch nicht mehr notwendig, da die Flüssigkeit bereits mit dem Dispergieren des Gases ausreichend durchmischt worden ist.

Dieser Unterschied macht sich besonders bei der naßchemischen Behandlung von Halbleiterscheiben bemerkbar. Eine möglichst gleichmäßige Behandlung der Werkstückoberflächen ist beispielsweise bei der Reinigung von Halbleiterscheiben und insbesondere dann erforderlich, wenn mit der naßchemischen Behandlung eine materialabtragende Wirkung erzielt werden soll, wie dies beim naßchemischen Ätzen von Halbleiterscheiben der Fall ist. So kommt es häufig vor, daß nach aufwendigen Formgebungsschritten, wie beispielsweise dem Läppen, Schleifen oder Kantenverrunden von Halbleiterscheiben, oberflächennahe Zerstörungen im Kristallgitter beseitigt werden müssen. Das erfindungsgemäße Verfahren gewährleistet dann zuverlässig, daß der Materialabtrag gleichmäßig erfolgt und die durch die mechanische Formgebung eingestellte Scheibengeometrie unverändert bleibt.

Obwohl das Verfahren besonders für die naßchemische Behandlung von Halbleiterscheiben vorgesehen ist, ist seine Verwendung nicht auf solche Werkstücke beschränkt.

Es wurde überraschenderweise gefunden, daß Werkstücke aus Halbleitermaterial mit einer deutlich erhöhten Geschwindigkeit naßchemisch gereinigt und/oder geätzt werden, wenn das Behandlungsmedium erfindungsgemäß erzeugt wird.

Mit dem beanspruchten Verfahren sind deshalb sowohl Halbleiterscheiben vorteilhaft zu behandeln als auch andere Werkstücke aus Halbleitermaterial, beispielsweise Kristallstäbe, Granulat, Halbleitermaterial in Form von Bruchstücken und Formkörper aus Halbleitermaterial.

Besonders geeignete Förderpumpen zur Durchführung des Verfahrens sind Pumpen, in denen das geförderte Behandlungsmedium stark beschleunigt wird. Vorzugsweise werden Kreiselpumpen oder Axialpumpen eingesetzt.

Wasser oder bekannte, wässerige Lösungen zum Reinigen oder wässerige Ätzlösungen sind die bevorzugt verwendeten Flüssigkeiten. Des weiteren ist es von Vorteil, aber nicht zwingend notwendig, der verwendeten Flüssigkeit ein Tensid zuzusetzten, vorzugsweise in einer Konzentration von 0,05 bis 1 Vol. %. Das Tensid hat einen stabilisierenden Einfluß auf die Gasbläschen und verlängert die Zeit, die im Mittel vergeht, bis individuelle Gasbläschen sich zu größeren Gasblasen vereinigt haben.

Als Gase, die in der Flüssigkeit homogen dispergiert werden, eignen sich beispielsweise Inertgas oder reaktive Gase wie Luft, Sauerstoff, Ozon, Fluor- oder Chlorwasserstoff, Stickstoffmonoxid oder Stickstoffdioxid oder beliebige Mischungen der genannten Gase.

In der bevorzugten Ausführungsform des Verfahrens werden Halbleiterscheiben einer naßchemischen Behandlung unterworfen, während derer die Oberflächen der Halbleiterscheiben einen gleichmäßigen Materialabtrag erfahren. Im einfachsten Fall besitzt die Flüssigkeit als Ätzlösung die materialabtragende Wirkung. Es ist jedoch nicht ausgeschlossen, daß die Flüssigkeit und das Gas diese Wirkung nur gemeinsam entfalten. Das von der Pumpe abgegebene Behandlungsmedium wird über mindestens einen Einlaß in eine Behandlungskammer eingeleitet, und zwar so, daß die zu behandelnden Halbleiterscheiben von dem Behandlungsmedium angeströmt werden, das heißt, der Förderstrahl der Pumpe ist auf die Halbleiterscheiben gerichtet. Zu diesem Zweck befinden sich die Halbleiterscheiben in einem Tragegestell, mit dessen Hilfe sie im Behandlungsmedium gehalten werden können und das den freien Zutritt des Behandlungsmediums an die Scheibenoberflächen erlaubt. Zunächst wird die Behandlungskammer mindestens soweit mit dem Behandlungsmedium gefüllt, daß die Halbleiterscheiben vollständig darin eingetaucht werden können. Dann empfiehlt es sich, jeweils soviel Behandlungsmedium über einen überlauf aus der Behandlungskammer zu entfernen wie über den Einlaß neu zugeführt wird. Das die Behandlungskammer verlassende Behandlungsmedium wird in einem Vorratsbehälter gesammelt und zweckmäßigerweise gefiltert der Förderpumpe wieder zugeführt, so daß ein Kreislauf des Behandlungsmediums resultiert. Weil zumindest ein Teil des Gases entweicht, nachdem das Behandlungsmedium die Behandlungskammer verlassen hat, wird ein entsprechender Teil Frischgas im Behandlungsmedium dispergiert, bevor das Behandlungsmedium wieder in die Behandlungskammer eingeleitet wird.

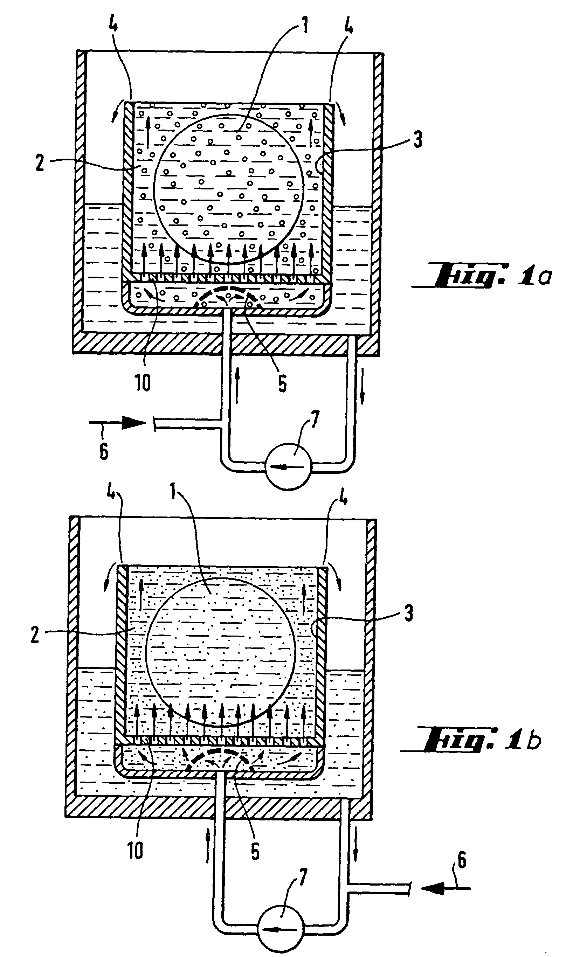

Im folgenden wird ein Vergleichsbeispiel, in dem Halbleiterscheiben mit einem einen Materialabtrag bewirkenden Ätzmittel behandelt worden sind, einem Beispiel der erfindungsgemäßen Behandlung von Halbleiterscheiben gegenübergestellt. Figur 1a zeigt schematisch den Versuchsaufbau des Vergleichsbeispiels auf, Figur 1b den entsprechenden Aufbau im Versuch des Beispiels.

### Vergleichsbeispiel

In einer Vorrichtung gemäß Fig. 1a, bestehend aus einer Behandlungskammer (3) mit perforiertem Kammerboden wurden 10 Siliciumscheiben mit einem Durchmesser von 150 mm einer Behandlung mit einem Fluorwasserstoff, Salpetersäure und Tensid enthaltenden, wässerigem Ätzmittel unterworfen. Zu diesem Zweck wurden die Siliciumscheiben (1), die sich in einem in der Figur nicht gezeigten Tragegestell befanden, in das Ätzmittel (2) getaucht. Eine Kreiselpumpe (7) förderte während der Scheibenbehandlung über eine unter dem Kammerboden angebrachte Verteilerleiste (5) Ätzmittel in die Behandlungskammer (3) nach. Das über den Überlauf (4) aus der Behandlungskammer abfließende Ätzmittel wurde der Ansaugseite der Pumpe zugeführt. Die Begasung des in der Behandlungskammer befindlichen Ätzmittels erfolgte dadurch, daß zwischen dem Pumpenausgang und der Verteilerleiste ein konstanter Stickstoffstrom (6) in den Kreislauf des Ätzmittels eingespeist wurde.

### Beispiel

Unter Verwendung der im Vergleichsbeispiel beschriebenen Vorrichtung wurden weitere 10 Siliciumscheiben mit einem Durchmesser von 150 mm behandelt. Die Zusammensetzung des Ätzmittels, die Pumpgeschwindigkeit und die Rate, mit der Sticksoff zudosiert wurde, blieben gegenüber dem Vergleichsbeispiel unverändert. Gemäß Fig. 1b wurde der Stickstoffstrom (6) im Unterschied zu Fig. 1a der Ansaugseite der Kreiselpumpe (7) zugeführt. Es wurde gefunden, daß bei vergleichbarem Materialabtrag mit der erfindungsgemäßen Scheibenbehandlung eine gegenüber der Scheibenbehandlung gemäß dem Vergleichsbeispiel um das zwei- bis dreifache erhöhte Ätzgeschwindigkeit erzielt werden konnte.

Die behandelten Scheiben beider Versuche wurden auf den erfolgten Materialabtrag untersucht. Ferner wurde als geometrischer Parameter die Ebenheit der Scheiben, d.h. die Abweichung der realen Oberfläche von einer ideal ebenen Oberfläche bestimmt und als sogenannte lokale Dickenvariation LTV quantifiziert. Als Referenzebene diente die Ebene parallel zur Scheibenrückseite bei Lage der Scheibe auf einem ebenen Vakuumhalter im angesaugten Zustand. Die in der Tabelle ausgewiesenen LTVₘₐₓ - Werte geben die bei der Untersuchung einer Scheibenoberfläche ermittelten größten lokalen Abweichungen in der Ebenheit an, wobei die Oberfläche jeder Scheibe in 69 quadratische Felder ("sites") mit einer Seitenlänge von 15 mm als lokale Meßbereiche eingeteilt war. Der Vergleich der Meßwerte beider Beispiele zeigt eine dramatische Verbesserung der Ebenheit bei der erfindungsgemäßen Behandlung der Siliciumscheiben.

**Tabelle:**

| Scheiben Nr. | Vergleichsbeispiel | | Beispiel | |
|---|---|---|---|---|
| | Materialabtrag (µm) | LTVₘₐₓ (µm) | Materialabtrag (µm) | LTVₘₐₓ (µm) |
| 1 | 30.52 | 4.76 | 30.20 | 0.12 |
| 2 | 31.31 | 5.22 | 30.25 | 0.22 |
| 3 | 30.09 | 4.96 | 30.12 | 0.22 |
| 4 | 30.91 | 5.72 | 30.17 | 0.15 |
| 5 | 32.13 | 5.31 | 30.22 | 0.25 |
| 6 | 30.25 | 4.98 | 30.25 | 0.08 |
| 7 | 33.14 | 5.12 | 30.16 | 0.02 |
| 8 | 32.29 | 5.65 | 30.16 | 0.15 |
| 9 | 32.63 | 5.29 | 30.08 | 0.21 |
| 10 | 31.58 | 5.37 | 30.27 | 0.17 |

## Patentansprüche

1. Verfahren zur naßchemischen Behandlung von Werkstücken aus Halbleitermaterial durch Anströmen der Werkstücke mit einem begasten Behandlungsmedium, dadurch
gekennzeichnet, daß
ein Gas und eine Flüssigkeit in einer Förderpumpe intensiv vermischt werden und die Förderpumpe eine homogene Dispersion feinster Gasbläschen in der Flüssigkeit abgibt, mit der die Werkstücke behandelt werden.

2. Verfahren nach Anspruch 1, dadurch gekennzeichnet, daß als Flüssigkeit Wasser oder eine wässerige Lösung zum Reinigen oder Ätzen von Halbleitermaterial verwendet wird.

3. Verfahren nach Anspruch 1 oder Anspruch 2, dadurch gekennzeichnet, daß der Flüssigkeit zur Stabilisierung der Gasbläschen ein Tensid zugesetzt ist.

4. Verfahren nach einem der Ansprüche 1 bis 3, dadurch gekennzeichnet, daß als Gas Inertgas, Luft, Sauerstoff, Ozon, Fluorwasserstoff, Chlorwasserstoff, Stickstoffmonoxid oder Stickstoffdioxid verwendet wird.

5. Verfahren nach einem der Ansprüche 1 bis 4, dadurch gekennzeichnet, daß die Werkstücke aus einer Gruppe ausgewählt werden, die Halbleiterscheiben, Kristallstäbe aus Halbleitermaterial, Halbleitermaterial in Form von Granulat, Halbleitermaterial in Form von Bruchstücken und Formkörper aus Halbleitermaterial umfaßt.

## Claims

1. Process for the wet-chemical treatment of workpieces of semiconductor material by exposing the workpieces to a flow of a gasified treatment medium used as the liquid, characterized in that a gas and a liquid are intensively mixed in a feed pump and the feed pump delivers a homogeneous dispersion of very fine gas bubbles in the liquid with which the workpieces are treated.

2. Process according to Claim 1, characterized in that water or an aqueous solution for cleaning or etching semiconductor material is used as the liquid.

3. Process according to Claim 1 or Claim 2, characterized in that a surfactant is added to the liquid to stabilize the gas bubbles.

4. Process according to one of Claims 1 to 3, characterized in that the gas which is used is inert gas, air, oxygen, ozone, hydrogen fluoride, hydrogen chloride, nitrogen monoxide or nitrogen dioxide.

5. Process according to one of Claims 1 to 4, characterized in that the workpieces are selected from a group which comprises semiconductor wafers, crystalline ingots of semiconductor material, semiconductor material in the form of granules, semiconductor material in the form of fragments and shaped bodies of semiconductor material.

## Revendications

1. Procédé pour le traitement chimique par voie humide de pièces en matériau semi-conducteur par soufflage des pièces à l'aide d'un milieu de traitement gazéifié, caractérisé en ce que l'on mélange fortement un gaz et un liquide dans une pompe d'alimentation, et en ce que la pompe d'alimentation produit une dispersion homogène de bulles de gaz très fines dans le liquide, avec laquelle les pièces sont traitées.

2. Procédé selon la revendication 1, caractérisé en ce que l'on utilise en tant que liquide de l'eau ou une solution aqueuse en vue du nettoyage ou du décapage du matériau semi-conducteur.

3. Procédé selon la revendication 1 ou 2, caractérisé en ce que l'on ajoute un agent tensioactif au liquide en vue de la stabilisation des bulles de gaz.

4. Procédé selon l'une quelconque des revendications 1 à 3, caractérisé en ce que l'on utilise en tant que gaz un gaz inerte, l'air, l'oxygène, l'ozone, le fluorure d'hydrogène, le chlorure d'hydrogène, le monoxyde d'azote ou le dioxyde d'azote.

5. Procédé selon l'une quelconque des revendications 1 à 4, caractérisé en ce que les pièces sont choisies parmi un groupe qui englobe les pastilles semi-conductrices, des barres cristallines en matériau semi-conducteur, du matériau semi-conducteur en forme de granulés, du matériau semi-conducteur en forme de fragments et de corps conformés en matériau semi-conducteur.
